# EUROPÄISCHE PATENTANMELDUNG

(11) **EP 4 047 644 A1**
(43) Veröffentlichungstag der Anmeldung: **24.08.2022**
(21) Anmeldenummer: 21158667.2
(22) Anmeldetag: 23.02.2021
(51) Int. Cl.: H01L 23/31, H01L 23/29, H01L 21/56

(54) **ELEKTRONISCHE BAUGRUPPE, FÜLLMITTEL UND VERFAHREN ZUR QUALITÄTSPRÜFUNG**

(71) Anmelder: Siemens Aktiengesellschaft, 80333 München (DE)
(72) Erfinder: Borwieck, Carsten, 14052 Berlin (DE); Franke, Martin, 14089 Berlin (DE); Jeske, Nora, 10555 Berlin (DE); Müller, Bernd, 16259 Falkenberg (DE); Wilke, Klaus, 12527 Berlin (DE)

(57) **Zusammenfassung**

Es wird eine elektronische Baugruppe mit wenigstens einem elektronischen Bauteil angegeben, welches zumindest teilweise mit einem elektrisch isolierenden Füllmittel umhüllt ist, wobei das elektrisch isolierende Füllmittel eine erste elektrisch isolierende Materialkomponente umfasst und als Nebenbestandteil eine zweite elektrisch isolierende Materialkomponente umfasst, welche als Röntgenkontrastmittel ausgebildet ist und eine höhere Dichte als die erste Materialkomponente aufweist.

Weiterhin wird ein elektrisch isolierendes Füllmittel zur Umhüllung eines elektronischen Bauteils in einer solchen Baugruppe angegeben sowie außerdem ein Verfahren zur Qualitätsprüfung einer solchen Baugruppe.

## Beschreibung

Die Erfindung betrifft eine elektronische Baugruppe mit wenigstens einem elektronischen Bauteil, welches zumindest teilweise mit einem elektrisch isolierenden Füllmittel umhüllt ist. Weiterhin betrifft die Erfindung ein Füllmittel für eine solche Baugruppe sowie ein Verfahren zur Qualitätsprüfung einer solchen elektronischen Baugruppe.

Aus dem Stand der Technik ist bekannt, dass elektronische Bauteile nach ihrem Einbau in elektronische Baugruppen mit elektrisch isolierenden Füllmitteln umhüllt werden. Beispielsweise werden bei der Flip-Chip-Montage Halbleiterbauteile in Form von nackten Halbleiter-Chips über sogenannte Bumps mit einem Schaltungsträger-Substrat elektrisch verbunden. Dieser Aufbau wird anschließend mit einem sogenannten Underfill unterfüllt. Dabei handelt es sich um ein elektrisch isolierendes Füllmittel, welches in den Zwischenraum zwischen Halbleiterbauteil und Substrat eingefüllt wird. Typischerweise wird hier ein elastischer, temperaturbeständiger Kunststoff verwendet, der dazu dient, die Verbindung zwischen Halbleiterbauteil und Substrat mechanisch so zu unterstützen, dass der Aufbau nicht aufgrund der unterschiedlichen thermischen Ausdehnungskoeffizienten von Halbleiterbauteil und Substrat beim Betrieb zerstört wird. Zusätzlich bewirkt der Underfill auch eine Kapselung der Chip-Unterseite gegenüber anderen unerwünschten Umgebungs-Einflüssen. Speziell werden aufgrund der elektrisch isolierenden Eigenschaften des Füllmittels dabei auch elektrische Kurzschlüsse vermieden.

Weiterhin ist es aus dem Stand der Technik auch bekannt, die Oberseite (also die vom Trägersubstrat einer Baugruppe abgewandte Seite) eines Bauteils mit einem elektrisch isolierenden Füllmittel in Form eines Gießharzes zu umhüllen. Dies dient vor allem dem Schutz des Bauteils vor chemischen und mechanischen Einflüssen der äußeren Umgebung sowie auch hier der Vermeidung von elektrischen Kurzschlüssen. Optional können mit einem solchen Vergussmittel auch außenliegende Bond-drähte eingekapselt und geschützt werden, mit denen das Bauteil von seiner Oberseite aus an das Substrat kontaktiert ist.

Sowohl für den Underfill als auch für ein solches frontseitiges Vergussmittel werden typischerweise Kunstharze eingesetzt, welche nach dem Auftragen eines flüssigen Ausgangsmaterials durch eine Vernetzungsreaktion ausgehärtet werden. Sowohl bei dem Vergießen bzw. Umhüllen des Bauteils als auch beim Aushärten können prinzipiell Defekte entstehen. Wünschenswert ist es, dass sich das Füllmittel lückenlos und defektfrei an die Oberfläche des Bauteils (und ggf. auch an die Oberfläche des Substrats) anschmiegt. So kann eine dauerhaft feste Verkapselung erreicht werden, welche auch bei längerem Betrieb und wiederholten Temperatur- und Belastungszyklen einen Schutz vor chemischen und mechanischen Schädigungen bietet. Ein unerwünschter Defekt, der dies beeinträchtigen kann, wäre zum Beispiel die Bildung von Luftblasen im Inneren des Füllmittels oder auch die Bildung von Blasen oder anderen Lufteinschlüssen im Grenzbereich zwischen Bauteil und Füllmittel oder auch im Grenzbereich zwischen Substrat und Füllmittel. Von solchen Füll-Lücken aus kann beispielsweise beim Betrieb der Baugruppe eine Delamination des Füllmittels erfolgen, wodurch der Schutz der Verkapselung oder Unterfüllung beeinträchtigt wird. Aber auch andere Arten von Defekten können schädlich sein. Insbesondere können sich auch Risse im Füllmittel oder Einschlüsse von Partikeln und anderen Fremdkörpern negativ auf die Qualität und Haltbarkeit der fertig montierten Baugruppe auswirken.

Häufig werden solche elektronischen Baugruppen in einem Serienfertigungsprozess hergestellt, und die Prozess-Qualität wird mit Verfahren der Qualitätssicherung entweder stichprobenartig oder sogar kontinuierlich, in Form einer hundertprozentigen Prüfung aller Baugruppen überwacht. Hierzu werden sowohl optische Inspektionsverfahren, aber auch Verfahren der Röntgen-Bildgebung eingesetzt.

Nachteilig bei den bekannten Baugruppen und den bekannten Verfahren zur Qualitätssicherung ist, dass vor allem kleinere Defekte in dem elektrisch isolierenden Füllmittel häufig übersehen werden. So können defekte Bauteile nicht immer rechtzeitig aussortiert werden und sie werden dann beispielsweise auf den Markt gebracht, obwohl sie die relevanten Spezifikationen nicht erfüllen. Vor allem bei modernen Bauteilen der Leistungselektronik werden die Abmessungen der einzelnen Strukturen und Elemente immer kleiner, so dass auch immer kleinere Defekte zuverlässig ausgeschlossen bzw. erkannt werden müssen. Hier stoßen die herkömmlichen Methoden der Qualitätssicherung an ihre Nachweisgrenzen, so dass vor allem die kleineren Defekte im isolierenden Füllmittel häufig unbemerkt bleiben. Dies führt dann zu nachträglichen Ausfällen der Baugruppen im Betrieb und damit insgesamt zu einer verringerten Zuverlässigkeit.

Aufgabe der Erfindung ist es daher, eine elektronische Baugruppe zur Verfügung zu stellen, welche die genannten Nachteile überwindet. Insbesondere soll eine solche elektronische Baugruppe möglichst zuverlässig auf Defekte im elektrisch isolierenden Füllmittel überprüft werden können. Dies soll ein frühzeitiges Erkennen und Aussortieren von defekten Baugruppen ermöglichen. Eine weitere Aufgabe der Erfindung ist es, ein Füllmittel zur Umhüllung von Bauteilen in solchen Baugruppen zur Verfügung zu stellen. Außerdem soll ein entsprechendes Verfahren zur Qualitätsprüfung bereitgestellt werden.

Diese Aufgaben werden durch die in Anspruch 1 beschriebene elektronische Baugruppe, das in Anspruch 14 beschriebene elektrisch isolierende Füllmittel und das in Anspruch 15 beschriebene Verfahren zur Qualitätsprüfung gelöst.

Die erfindungsgemäße elektronische Baugruppe umfasst wenigstens ein elektronisches Bauteil, welches zumindest teilweise mit einem elektrisch isolierenden Füllmittel umhüllt ist. Dieses elektrisch isolierende Füllmittel umfasst wenigstens eine erste elektrisch isolierende Materialkomponente und als Nebenbestandteil eine zweite elektrisch isolierende Materialkomponente, wobei die zweite Materialkomponente als Röntgenkontrastmittel ausgebildet ist und eine höhere Dichte als die erste Materialkomponente aufweist.

Das wenigstens eine elektronische Bauteil kann insbesondere auf einem Substrat angeordnet sein, welches beispielsweise einen Schaltungsträger der Baugruppe bilden kann. Es können besonders vorteilhaft auch mehrere elektronische Bauteile auf demselben Substrat angeordnet sein. Wesentlich im Zusammenhang mit der vorliegenden Erfindung ist jedoch, dass wenigstens ein solches Bauteil auf die beschriebene Weise mit einem isolierenden Füllmittel umhüllt ist. Diese Umhüllung muss nicht vollständig sein, sondern es reicht aus, wenn zumindest eine Teilfläche des Bauteils von diesem Füllmittel bedeckt ist. So kann zum Beispiel eine vom Substrat abgewandte Hauptfläche des Bauteils mit dem Füllmittel bedeckt sein, so dass sich in diesem Bereich eine Kapselung gegen Einflüsse der äußeren Umgebung ergibt. Alternativ oder zusätzlich kann ein Bereich zwischen dem Bauteil und dem Substrat mit dem Füllmittel unterfüllt sein. Unabhängig von der genauen Anordnung des Füllmittels auf der Oberfläche des Bauteils und relativ zum Substrat ist das wesentliche Merkmal, dass das Füllmittel als Nebenbestandteil ein Röntgenkontrastmittel umfasst, welches ebenfalls als elektrisch isolierendes Material ausgebildet ist. Die genannte erste Materialkomponente kann dabei insbesondere den Hauptbestandteil ausbilden.

Das Röntgenkontrastmittel dient dazu, mögliche Defekte im Bereich des Füllmittels bzw. seiner Grenzflächen, durch ein bildgebendes Verfahren mittels Röntgenstrahlung leichter sichtbar zu machen. Bei dem Röntgenkontrastmittel kann es sich dabei insbesondere um ein röntgenpositives Kontrastmittel handeln, also mit anderen Worten um einen Zusatzstoff, welcher die Röntgenopazität des Füllmittels erhöht. Die erfindungsgemäße Ausgestaltung bewirkt den Vorteil, dass die elektronische Baugruppe durch ein Qualitätssicherungs-Verfahren mit einer bildgebenden Röntgendiagnostik wesentlich einfacher als herkömmliche Baugruppen auf Defekte überprüft werden kann. Dies ist vor allem im Zusammenhang mit einer Serienfertigung der Baugruppen nützlich, bei der sich an die Herstellung der Baugruppen eine Qualitätssicherung mittels einer Röntgenmessung anschließt. Da das Röntgenkontrastmittel ebenfalls durch ein isolierendes Material gegeben ist, werden die elektrisch isolierenden Eigenschaften des Füllmittels durch diesen Zusatzstoff nicht beeinträchtigt.

Die typischen Defekte, die sich bei der Umhüllung eines Bauteils mit einem isolierenden Füllmittel ausbilden, sind beispielsweise Luftblasen, Füll-Lücken in engen Spalten, Delaminationen an Grenzflächen, Risse im Inneren des Füllmittels und/oder Einschlüsse von unerwünschten Partikeln. Vor allem diejenigen Defekte, bei denen an der betroffenen Stelle ein unerwünschter Lufteinschluss vorliegt (z.B. in Form einer Blase, einer luftgefüllten Lücke oder eines luftgefüllten Risses), kann der Defekt durch den Unterschied der Röntgenopazität zwischen dem Defekt und dem defektfreien Füllmittel sichtbar gemacht werden. Dieser Röntgenkontrast kann durch die erfindungsgemäße Beimischung eines Röntgenkontrastmittels mit vergleichsweise höherer Dichte in das Füllmittel erhöht werden, wodurch die Zuverlässigkeit bei der Detektion von Defekten deutlich verbessert werden kann. Diese Kontrastverbesserung ist beim Vorliegen von "Luft-Defekten" am höchsten, sie kann aber auch hilfreich sein, um Einschlüsse von anderen Partikeln mit geringer Röntgenopazität leichter sichtbar zu machen. Insgesamt trägt also die erfindungsgemäße Ausgestaltung dazu bei, die Detektierbarkeit von möglichen Defekten zu verbessern und damit eine sicherere Qualitätskontrolle zu ermöglichen. So können defektbehaftete Baugruppen mit einer höheren Zuverlässigkeit rechtzeitig aussortiert werden. Das Auftreten von Schäden und Fehlern beim Betrieb der (erfolgreich geprüften) Baugruppen kann wirksam reduziert werden, und die Zuverlässigkeit bei der Einhaltung der Spezifikationen der Baugruppen steigt.

Das erfindungsgemäße, elektrisch isolierende Füllmittel dient zur Umhüllung eines elektronischen Bauteils in einer elektronischen Baugruppe. Das Füllmittel umfasst eine erste elektrisch isolierende Materialkomponente und als Nebenbestandteil eine zweite elektrisch isolierende Materialkomponente, welche als Röntgenkontrastmittel ausgebildet ist und eine höhere Dichte als die erste Materialkomponente aufweist.

Das erfindungsgemäße Verfahren dient zur Qualitätsprüfung einer erfindungsgemäßen elektronischen Baugruppe. Dabei wird mittels einer Röntgenmessung eine Bildgebung der Baugruppe erreicht. Die Vorteile des erfindungsgemäßen Füllmittels und des erfindungsgemäßen Verfahrens ergeben sich analog zu den oben beschriebenen Vorteilen der erfindungsgemäßen Baugruppe. Insbesondere wird der Kontrast der bildgebenden Röntgenmessung durch das Röntgenkontrastmittel verstärkt.

Vorteilhafte Ausgestaltungen und Weiterbildungen der Erfindung gehen aus den von den Ansprüchen 1 abhängigen Ansprüchen sowie der folgenden Beschreibung hervor. Dabei können die beschriebenen Ausgestaltungen der Baugruppe, des Füllmittels und des Verfahrens zur Qualitätsprüfung allgemein vorteilhaft miteinander kombiniert werden.

Gemäß einer allgemein vorteilhaften Ausführungsform kann das Röntgenkontrastmittel zumindest ein chemisches Element mit einer Ordnungszahl von 22 oder mehr aufweisen. Mit anderen Worten kann das Kontrastmittel Titan oder ein Element mit einer höheren Ordnungszahl als Titan umfassen. Besonders bevorzugt liegt sogar ein Element mit einer Ordnungszahl von wenigstens 38 vor. Mit anderen Worten kann dann Strontium oder ein Element mit einer höheren Ordnungszahl als Strontium umfasst sein, insbesondere alternativ auch Zirconium. Ganz besonders bevorzugt liegt sogar ein Element mit einer Ordnungszahl von wenigstens 53 vor.

Allgemein führt eine hohe Ordnungszahl entsprechend den genannten Bereichen dazu, dass das Röntgenkontrastmittel insgesamt eine besonders hohe Röntgenopazität aufweist und somit der Kontrast einer bildgebenden Qualitätsprüfung besonders wirksam erhöht ist.

Zusätzlich zu einem enthaltenen chemischen Element mit der beschriebenen hohen Ordnungszahl kann auch die Dichte des Kontrastmittel vergleichsweise hoch sein. Erfindungsgemäß ist sie in jedem Fall höher als die Dichte der ersten Materialkomponente und liegt insbesondere bei wenigstens 2 g/cm³. Vor allem die Kombination aus hoher Dichte und hoher Ordnungszahl von wenigstens einem enthaltenen chemischen Element bewirkt insgesamt eine besonders hohe Röntgenabsorption des Kontrastmittels und damit einen besonders guten Kontrast in der Bildgebung.

Besonders vorteilhaft ist es, wenn die zweite Materialkomponente nur dazu dient, als Röntgenkontrastmittel zu wirken und daher keine weitere Funktionalität in dem Füllmittel aufweist. Dann kann der Anteil des Röntgenkontrastmittel im Wesentlichen im Hinblick auf seinen Zweck bei der Kontrastverstärkung und unabhängig von anderen funktionellen Eigenschaften des Füllmittels gewählt werden.

Allgemein vorteilhaft kann das Röntgenkontrastmittel Iod, Barium, Zirconium, Wolfram, Strontium und/oder Titan umfassen. Dies sind Elemente mit vergleichsweise hoher Ordnungszahl, welche zum Teil bereits in der Medizintechnik als Bestandteile von Kontrastmitteln zum Einsatz kommen. Bevorzugt umfasst das Kontrastmittel eine elektrisch isolierende anorganische oder organische Verbindung eines der genannten Elemente. Dabei kann es sich prinzipiell um eine ionische oder auch um eine nicht-ionische Verbindung handeln. Im Falle einer Verbindung kann diese allgemein vorteilhaft (ionisch oder nichtionisch) in dem Füllmittel bzw. in einer seiner Materialkomponenten gelöst sein. So ergibt sich eine besonders gleichmäßige Verteilung des Kontrastmittels in dem Füllmittel, was die räumliche Auflösung und Detektion von möglichen Defekten erleichtert. Alternativ kann das Kontrastmittel aber auch als Dispersion von (insbesondere anorganischen) Mikro- oder Nanopartikeln in der ersten Materialkomponente des Füllmittels vorliegen. Bei solchen Mikro- oder Nanopartikeln kann es sich insbesondere auch um polymerumhüllte anorganische Partikel handeln. Eine solche Umhüllung verbessert die Dispergierfähigkeit in einer polymeren Materialkomponente.

Wenn Barium als kontrastwirksames Element zum Einsatz kommt, ist die Verbindung Bariumsulfat als Bestandteil des Kontrastmittels besonders bevorzugt. Bariumsulfat hat sich insbesondere als Bestandteil von Dispersionen in der Medizintechnik als Röntgenkontrastmittel etabliert. In ähnlicher Weise kann Zirconium beispielsweise in Form von Zirconiumdioxid im Kontrastmittel vorliegen. Bei der Verwendung von Iod als kontrastverstärkendem Element ist es dagegen besonders bevorzugt, wenn dieses innerhalb einer organischen Iodverbindung gebunden ist. Auch hier sind aus der Medizintechnik zahlreiche Verbindungen bekannt, welche insbesondere auch in organischen Substanzen - beispielsweise anderen Materialkomponenten des Füllmittels oder deren flüssigen Ausgangsstoffen löslich sind. Alternativ kommen aber auch anorganische Iodverbindungen in Betracht.

Im Unterschied zur Verwendung von Kontrastmitteln in der Medizintechnik können hier allgemein auch toxischere Verbindungen bzw. Elemente zum Einsatz kommen, da das Kontrastmittel hier nur der Qualitätsprüfung einer elektronischen Baugruppe dient und nicht in einem lebenden Körper aufgenommen wird.

Allgemein und unabhängig von der jeweiligen chemischen Zusammensetzung des Kontrastmittels kann dieses im elektrisch isolierenden Füllmittel homogen verteilt sein. Die relevante Größenskale für diese Homogenität kann dabei beispielsweise bei 50 µm oder weniger, bevorzugt 10 µm oder weniger und besonders bevorzugt sogar im Sub-Mikrometer-Bereich liegen. Dabei soll also bei einem eventuellen Vorliegen von Kontrastmittel-Partikeln die Partikelgröße insbesondere höchstens 50 µm sein, bevorzugt höchstens 10 µm sein und besonders bevorzugt im Sub-Mikrometer-Bereich liegen. Eine besonders homogene Verteilung kann dabei erzielt werden, wenn das Kontrastmittel in einer anderen Komponente des Füllmittels gelöst ist. Dazu kann es bei der Herstellung des Füllmittels insbesondere in einem seiner Ausgangsstoffe gelöst sein, beispielsweise in einem flüssigen Ausgangsstoff eines Kunstharzes. Selbst bei dieser Ausführungsform, bei der das Kontrastmittel gelöst vorliegt, muss die Verteilung im fertigen Füllmittel aber nicht absolut homogen sein: Beispielsweise kann das Kontrastmittel in einem Kunstharz physikalisch gelöst sein und tatsächlich in dieser Komponente homogen verteilt sein. Es kann aber sein, dass diesem Kunstharz zusätzlich ein Füllstoff in Form von fein verteilten Partikeln beigemischt ist. In diesem Fall wäre das Kontrastmittel dann nur im umgebenden Kunstharz (als Matrix) und nicht in den eingebetteten Füllstoff-Partikeln enthalten, was in einem hochauflösenden Röntgenbild zu "Löchern" der Röntgenabsorption im Bereich der Füllstoff-Partikel führen wird. Trotzdem würde auch in einem solchen Fall zumindest eine zusätzliche Körnung dadurch vermieden, dass das Kontrastmittel in einer Komponente des Füllmittels gelöst und darin homogen verteilt ist. Auch dies würde daher insgesamt zu einem verbesserten Röntgenkontrast bei der Detektion von Defekten beitragen.

Es ist aber auch nicht zwingend notwendig, dass das Kontrastmittel in einer Komponente des Füllmittels gelöst ist. Alternativ kann das Röntgenkontrastmittel auch in der ersten Materialkomponente dispergiert sein. Auch in diesem Fall ist es allerdings besonders vorteilhaft, wenn die Dispersion auf der oben genannten Größenskala als homogen anzusehen ist. Hierzu sollten die durch das Kontrastmittel gebildeten Partikel insbesondere kleiner als die genannte Größenskala sein. Auch möglicherweise vorhandene Agglomerate solcher Partikel sollten vorteilhaft kleiner als die genannte Größenskala sein. Besonders vorteilhaft kann das Röntgenkontrastmittel in Form von fein dispergierten Nanopartikeln vorliegen. Um die Dispergierfähigkeit solcher Nanopartikel zu erhöhen, können diese optional mit einer Polymerumhüllung versehen sein.

Allgemein ist es besonders bevorzugt, wenn eine solche Dispersion homodispers ist, wenn also mit anderen Worten die Partikel in der Dispersion eine im Wesentlichen einheitliche Größe aufweisen. Auch bei einer derartigen feinen Verteilung des Kontrastmittels in Form eines Pulvers in einer Dispersion liegt für die Zwecke der typischen hochauflösenden Röntgen-bildgebung effektiv ein homogen röntgenabsorbierendes Material vor, so dass Defekte mit vergleichsweise größeren Abmessungen leichter sichtbar gemacht werden können.

Allgemein vorteilhaft kann das Röntgenkontrastmittel in dem Füllmittel einen Volumenanteil ausmachen, welcher zwischen 0,5 Volumenprozent und 20 Volumenprozent liegt.

Ein Gewichtsanteil im genannten Bereich ist zweckmäßig, denn einerseits sollte der Anteil an Kontrastmittel nicht zu niedrig ausfallen, um bei einer Qualitätsprüfung durch Röntgen-bildgebung tatsächlich eine messbare Erhöhung des Röntgenkontrasts bewirken zu können. Bei der Verwendung von Kontrastmitteln in der Medizintechnik hat sich aber gezeigt, dass auch sehr geringe Konzentrationen von stark röntgenabsorbierenden Kontrastmitteln schon eine signifikante Steigerung des Bildkontrasts im Verhältnis zu Luft und anderen schwach röntgenabsorbierenden Materialien bewirken können. Andererseits sollte die Konzentration des Kontrastmittels aber auch nicht zu hoch sein, da durch diesen Zusatzstoff die übrigen Eigenschaften des Füllstoffs nicht allzu stark beeinflusst werden sollten. Bei einem Anteil im genannten Bereich kann der Einfluss des Kontrastmittels auf die thermischen, mechanischen und elektrischen Eigenschaften und auch auf die Materialkosten des Füllmittels im Vergleich zu den herkömmlichen Füllmitteln allgemein vorteilhaft gering gehalten werden.

Gemäß einer allgemein vorteilhaften Ausführungsform ist die erste Materialkomponente ein Polymer und besonders bevorzugt ein Polymerharz. Es kann sich insbesondere um ein polymeres Gießharz handeln, mit anderen Worten um einen Duroplasten. Ein solches Gießharz kann durch einen Härtungsschritt, bei dem eine Vernetzungsreaktion abläuft, aus mehrheitlich flüssigen Ausgangsstoffen gebildet sein. Diese Ausgangsstoffe können vor dem Härten prinzipiell als Ein-Komponenten-System oder auch als Mehr-Komponenten-System vorliegen. Häufig wird dazu ein Gemisch aus dem eigentlichen Harz und einem Härter eingesetzt, wobei das Gemisch durch den Einfluss von Wärme und/oder sichtbarem bzw. ultraviolettem Licht vernetzt wird. Optional können dabei auch weitere Komponenten zum Einsatz kommen, beispielsweise Füllstoffe und/oder Farbstoffe, welche in dem Kunstharz gelöst oder dispergiert sein können. Häufig kommen hierfür z.B. Quarz- oder Glaspartikel zum Einsatz. Bei dem im Rahmen der Erfindung vorliegenden Kontrastmittel handelt es sich also um ein spezifischen Füllstoff, welcher alternativ oder auch zusätzlich zu solchen bekannten Füllstoffen vorhanden sein kann.

Allgemein vorteilhaft kann ein solches Kunstharz ein Epoxidharz, ein Silikonharz, ein Polyurethanharz, ein Acrylharz, ein Polyesterharz, ein Vinylesterharz und/oder ein Phenolharz sein bzw. ein solches Material umfassen. Bei den genannten Stoffen kann es sich insbesondere um den Hauptbestandteil des Füllstoffs handeln, wobei optional weitere Zusatzstoffe vorliegen können, wie oben beschrieben. Im Zusammenhang mit dem Verguss bzw. der Unterfüllung von elektronischen Bauteilen sind Epoxidharze, Silikonharze, Polyurethanharze und Acrylharze besonders bevorzugt. Ganz besonders bevorzugt sind Epoxidharze, da diese zur Umhüllung von elektronischen Bauteilen besonders häufig zum Einsatz kommen.

Zusätzlich zu dem harzbildenden Hauptbestandteil kann das Kunstharz ein Härtermaterial umfassen, mit dem eine Vernetzungsreaktion des Kunstharzes bewirkt worden ist. Mit anderen Worten kann das Kunstharz aus einem Mehr-Komponenten-System gebildet sein, wobei die einzelnen Ausgangsstoffe nach der Vernetzungsreaktion zwar nicht mehr als separate Bestandteile vorliegen, aber die Verwendung eines Härtermaterials durchaus an der chemischen Zusammensetzung des vernetzten Kunstharzes noch erkennbar ist. Die Vernetzung kann mittels des Härters entweder rein thermisch oder aber auch (alternativ oder zusätzlich) durch Einwirkung von Strahlung vorursacht worden sein.

Gemäß einer ersten Ausführungsvariante für die Art der Umhüllung kann das wenigstens eine elektronische Bauteil auf einem Substrat angeordnet sein und ein Bereich zwischen dem elektronischen Bauteil und dem Substrat kann mit dem elektrisch isolierenden Füllmittel unterfüllt sein. Mit anderen Worten handelt es sich bei dem Füllmittel bei dieser Variante um einen sogenannten "Underfill". Das genannte Substrat kann allgemein ein elektrischer Schaltungsträger sein, welcher vorteilhaft elektrisch mit dem aufgebrachten Bauteil verbunden ist. Der Schaltungsträger kann auch mehrere Bauteile tragen. Von diesen können auch insbesondere mehrere entsprechend der Erfindung unterfüllt und/oder von außen vergossen sein. Das wenigstens eine elektronische Bauteil kann insbesondere ein nacktes Halbleiter-Bauelement sein. Dieses kann beispielsweise über sogenanntes "Bump Bonding", also über kleine hubbelartige Erhöhungen aus elektrisch leitfähigem Material, mit einzelnen Kontaktstellen auf dem Substrat verbunden sein. Die dabei im Bereich zwischen den einzelnen Bumps gebildete Lücke zwischen Substrat und Bauelement ist dann insbesondere mit dem Underfill möglichst vollständig aufgefüllt. Dies dient der Vermeidung von elektrischen Kurzschlüssen zwischen den Bumps und einer Erhöhung der mechanischen Stabilität im Betrieb, insbesondere bei Temperaturänderungen. Auch kann damit optional die thermische Ankopplung des Bauteils an das Substrat und somit die Kühlung verbessert werden. Das beschriebene Prüfverfahren zur Qualitätssicherung mittels Röntgenbildgebung dient dann insbesondere zur Prüfung auf mögliche Defekte bei der vollständigen Unterfüllung.

Gemäß einer zweiten Ausführungsvariante für die Art der Umhüllung kann das wenigstens eine elektronische Bauteil auf einem Substrat angeordnet sein und ein von dem Substrat abgewandter Bereich des elektronischen Bauteils kann von dem elektrisch isolierenden Füllmittel umhüllt sein. Dadurch wird insbesondere eine Kapselung des Bauteils gegenüber der äußeren Umgebung erreicht. Eine solche Kapselung kann prinzipiell alternativ oder auch zusätzlich zu der oben beschriebenen Unterfüllung vorliegen. Die Kapselung kann einen Schutz vor Umwelteinflüssen bewirken und das Bauteil so vor chemischer und/oder mechanischer Beschädigung schützen. Auch kann es die zwischen dem Bauteil und dem Substrat möglicherweise vorliegenden elektrischen Verbindungen vor elektrischen Kurzschlüssen schützen. Auch die elektrischen Verbindungen, beispielsweise in Form von offenliegenden feinen Drähten können in bestimmten Ausführungsformen durch das Füllmittel vor Beschädigung geschützt werden. Die beschriebene außenliegende Umhüllung gemäß dieser Ausführungsvariante kann allgemein ein sogenannter "Glob Top" sein.

Allgemein kann das wenigstens eine elektronische Bauteil ein Halbleiter-Bauelement sein. Dieses kann insbesondere nach einem Verfahren der Nacktchipmontage (COB für englisch "Chip on Board) auf dem Substrat aufgebracht sein.

Besonders bevorzugt kann es sich bei dem Bauteil um ein Bauteil der Leistungselektronik handeln. Die Baugruppe ist dann also eine leistungselektronische Baugruppe. Die Vorteile der vorliegenden Erfindung kommen bei dieser Ausführungsform besonders zum Tragen, da einerseits hier die sichere Vermeidung von elektrischen Kurzschlüssen besonders wichtig ist und andererseits gerade hier ein Trend zu immer kompakteren Bauteilen besteht, und somit die zuverlässige Detektion von sehr kleinen Defekten immer wichtiger wird.

Bei einer bevorzugten Ausführungsform des erfindungsgemäßen Füllmittels kann es sich um ein sogenanntes Underfill-Material handeln. Bei einer alternativen Ausführungsform des erfindungsgemäßen Füllmittels kann es sich um ein sogenanntes Glob-Top-Material handeln.

Gemäß einer vorteilhaften Ausführungsform des Verfahrens zur Qualitätsprüfung wird diese Prüfung als Teil eines Verfahrens zur Serienfertigung solcher elektronischer Baugruppen durchgeführt. Besonders bevorzugt handelt es sich um eine Qualitätsprüfung aller in der Serie hergestellten Baugruppen, also mit anderen Worten um eine 100%-Überprüfung.

Die beschriebene bildgebende Röntgenmessung kann unter Verwendung einer Röntgenquelle und eines Röntgendetektors durchgeführt werden. Insbesondere handelt es sich dabei um eine räumlich aufgelöste Messung, so dass ein Abbild der Baugruppe (oder eines Teils davon) erzeugt wird. Im Rahmen dieser Messung kann insbesondere die lokale Röntgenabsorption innerhalb der Baugruppe gemessen werden. Alternativ oder zusätzlich ist aber auch die Messung einer Röntgenfluoreszenz möglich.

Bei der bildgebenden Röntgenmessung kann es sich beispielsweise um eine einfache Durchleuchtungs-Messung handeln, bei der ein zweidimensionales Bild der Baugruppe als Projektion entlang der Strahlrichtung erzeugt wird. Alternativ kann es sich aber auch um ein Verfahren der Röntgen-Computertomographie handeln, durch welches die ganze Baugruppe mittels einer Bildrekonstruktion dreidimensional abgebildet wird. Es kann sich also bei dem Prüfverfahren mit anderen Worten um ein Verfahren der industriellen Computertomographie handeln. Hierbei sind allgemein sehr feine Auflösungen erzielbar, wobei die Detektion von kleinen Defekten durch die erfindungsgemäße Ausgestaltung noch weiter verbessert wird. Bei dem angewendeten CT-Verfahren kann es sich beispielsweise um ein zweidimensionales CT-Verfahren mit einzelnen Schichtaufnahmen oder um ein dreidimensionales CT-Verfahren mit einem größeren Strahlfächer und einem zweidimensional pixelierten Detektorfeld handeln. Auch ein Helix-CT-Verfahren und/oder verschiedene Laminographie-Verfahren können in diesem Zusammenhang vorteilhaft zum Einsatz kommen.

Nachfolgend wird die Erfindung anhand zweier bevorzugter Ausführungsbeispiele unter Bezugnahme auf die angehängten Zeichnungen beschrieben, in denen:
- Figur 1: einen schematischen Querschnitt einer Baugruppe nach einem ersten Beispiel der Erfindung zeigt und
- Figur 2: einen schematischen Querschnitt einer Baugruppe nach einem zweiten Beispiel der Erfindung zeigt.

In den Figuren sind gleiche oder funktionsgleiche Elemente mit gleichen Bezugszeichen versehen.

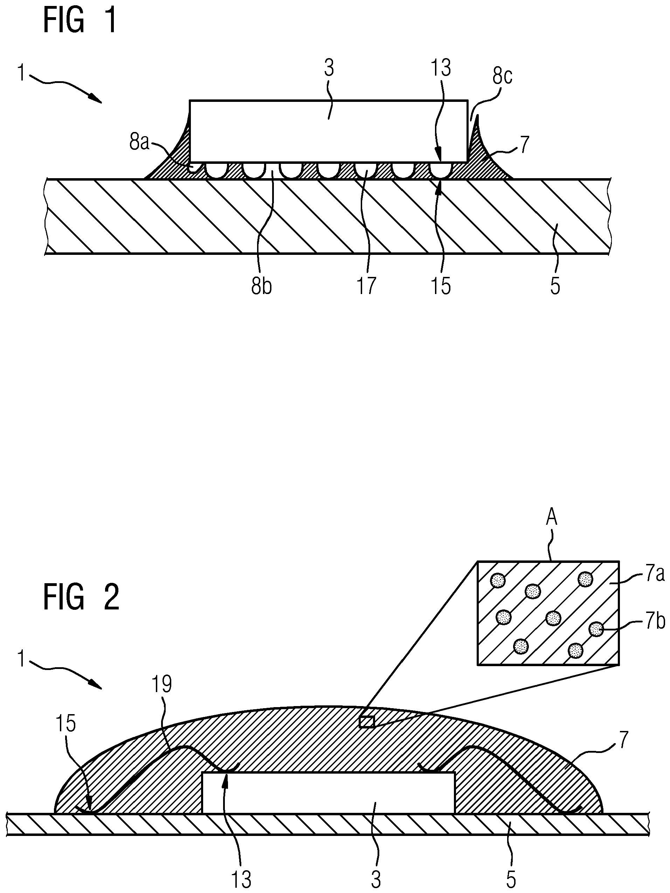

In Figur 1 ist eine elektronische Baugruppe 1 nach einem ersten Ausführungsbeispiel der Erfindung im schematischen Querschnitt gezeigt. Gezeigt ist ein Substrat 5, welches den Schaltungsträger der Baugruppe ausbildet, und ein darauf angeordnetes elektronisches Bauteil 3. Es ist nur ein Ausschnitt aus dem Substrat 5 gezeigt, welches in anderen Bereichen auch noch weitere elektronische Bauteile tragen kann. Die vorhandenen Bauteile sind mit dem Substrat und gegebenenfalls auch untereinander über elektrische Leitungen verbunden, welche hier der Übersichtlichkeit halber nicht näher dargestellt sind. Die einzelnen Leitungen können im Bereich einer der Oberflächen des Substrats oder auch in tieferliegenden Schichtebenen verlaufen. Die elektrische Verbindung des Bauteils 3 mit dem Substrat 5 erfolgt jedenfalls über an der Oberfläche des Substrats 5 liegende Kontaktstellen 15. Beim gezeigten Beispiel ist die Kontaktierung dieser Kontaktstellen an entsprechende Kontaktstellen 13 des Bauteils über eine Mehrzahl von Bond-Bumps 17 realisiert. Bei dem Bauteil handelt es sich in diesem Beispiel um ein Halbleiter-Bauelement, insbesondere um ein leistungselektronisches Bauelement. Dieses Halbleiter-Bauelement liegt als nackter (gehäuseloser) flacher Chip vor und wurde mittels sogenannter Flip-Chip-Montage auf dem Substrat montiert. Die einzelnen Bond-Bumps sind halbkugelförmige Elemente aus Lotmaterial, wobei durch deren Erwärmung eine dauerhafte elektrische Verbindung zwischen den Kontaktstellen 15 des Substrats 5 und den Kontaktstellen 13 des Bauteils hergestellt wurde. Nach der Herstellung dieser Kontakte ist der Zwischenraum zwischen dem Bauteil 3 und dem Substrat 5 mit einem elektrisch isolierenden Füllmittel 7 aufgefüllt worden. Es handelt sich also um ein sogenanntes Underfill-Material, wobei sich dieser Underfill im gezeigten Beispiel auch auf die schmalen Seitenflächen des Bauteils 3 erstreckt.

Das Füllmittel 7 ist hier als Gießharz ausgebildet, beispielsweise mit einem Epoxidharz als Hauptbestandteil. Das Gießharz kann durch eine Vernetzungsreaktion zwischen einem Epoxidharz und einem beigemischten Härtermaterial gebildet worden sein, so dass ein Duroplast ausgebildet wurde. Die Vernetzung kann beispielsweise thermisch bewirkt worden sein. Zusätzlich zu den beschriebenen Komponenten (Harz und Härter) umfasst das Füllmittel 7 hier außerdem zumindest einen weiteren Bestandteil, welcher als Röntgenkontrastmittel wirkt. Insbesondere handelt es sich um einen Bestandteil mit einer im Vergleich zu den übrigen Komponenten deutlich erhöhten Röntgenopazität. Das Kontrastmittel weist hierzu beispielsweise ein Element mit einer hohen Ordnungszahl und außerdem insgesamt eine vergleichsweise hohe Dichte auf. Das Kontrastmittel ist innerhalb des Füllmittels fein verteilt und kann beispielsweise in den übrigen Komponenten (oder zumindest einer davon) gelöst vorliegen. Alternativ kann es auch fein dispergiert sein. In jedem Fall bewirkt das Kontrastmittel, dass die Röntgenopazität des Füllmittels erhöht ist und somit ein Kontrast bei einer bildgebenden Qualitätsprüfung mittels Röntgenstrahlung erhöht sein kann. Insbesondere ist eine solche Kontrasterhöhung im Bereich von möglichen Defekten relevant, bei denen Luft oder andere im Vergleich zum Füllmittel geringer röntgenabsorbierende Materialien unerwünschterweise anstatt des Füllmittels vorliegen. Nur beispielhaft sind in Figur 1 drei solche Defekte gezeigt, welche durch das Vorliegen des Kontrastmittels im Füllmittel 7 leichter abgebildet werden können: So ist als erster Defekt 8a eine Luftblase auf der Unterseite des Bauelements 3 eingeschlossen. Im Bereich einer solchen Luftblase ist die Verkapselung des Chips lokal unterbrochen, und es kann zu einer Schädigung der Oberfläche und/oder zu einem elektrischen Kurzschluss im Bereich des benachbarten Kontaktpunkts kommen. Durch den erhöhten Röntgenkontrast zwischen der Luftblase 8a und dem um das Kontrastmittel angereicherten Füllmittel 7 kann eine solche Luftblase besser in der Qualitätsprüfung identifiziert werden. Ähnlich verhält es sich mit dem zweiten Defekt 8b, welcher als Fülllücke zwischen benachbarten Bond-Bumps ausgebildet ist. Auch dies ist ein unerwünschter Lufteinschluss, der aufgrund des Kontrastmittels leichter sichtbar gemacht werden kann. Der dritte beispielhafte Defekt 8c ist eine Delaminationsstelle, also eine Stelle, an der sich nachträglich ein Riss zwischen dem Bauteil 3 und dem zuvor daran anliegenden Füllmittel 7 gebildet hat. Diese Rissbildung kann beispielsweise beim Aushärten entstanden sein. Ausgehend von einer solchen Delaminationsstelle kann es zu weiteren, großflächigeren Delaminationen kommen. Insgesamt können hier Schädigungen durch Umwelteinflüsse und elektrische Kurzschlüsse die Folge sein. Auch solche Delaminationsstellen können aufgrund des enthaltenen Kontrastmittels leichter sichtbar gemacht werden.

In Figur 2 ist eine elektronische Baugruppe 1 nach einem zweiten Ausführungsbeispiel der Erfindung gezeigt. Auch hier ist ein Substrat 5 mit wenigstens einem Bauteil 3 bestückt, welches auch in diesem Beispiel als Halbleiter-Bauelement ausgebildet ist. Im Unterschied zum Beispiel der Figur 1 ist hier das Bauelement 3 jedoch nicht über Bond-Bumps, sondern über feine Bond-Drähte 19 mit den entsprechenden Kontaktstellen 15 des Substrats verbunden. Entsprechend sind die Kontaktstellen 13 des Bauelements auf seiner vom Substrat 5 abgewandten Hauptfläche angeordnet. Um das Bauelement 3 vor Umgebungseinflüssen und elektrischen Kurzschlüssen zu schützen und insbesondere auch die Bond-Drähte 19 vor einer Beschädigung zu schützen, ist das Bauteil auf seiner vom Substrat 5 abgewandten Seite mitsamt den Bond-Drähten 19 von einem Füllmittel umgossen. Es handelt sich hier also um ein Vergussmittel, welches von außen auf die freiliegenden Bereiche aufgebracht wurde, beispielsweise um einen sogenannten Glob Top.

Figur 2 enthält auch eine Ausschnittsvergrößerung A, in welcher die Zusammensetzung des Füllmittels (nur äußerst schematisch) dargestellt ist. Bei diesem Beispiel ist die zweite Materialkomponente 7b (also das Röntgenkontrastmittel) in Form eines feinen Pulvers in der ersten Materialkomponente 7a (einem Gießharz) dispergiert. Ähnlich wie beim vorhergehenden Beispiel ist auch hier das Gießharz aus im Wesentlichen flüssigen Ausgangsstoffen durch eine Vernetzungsreaktion erhalten worden. Die Partikel des Kontrastmittels 7b sind in dieser Matrix fein verteilt eingebettet. Beim Beispiel der Figur 2 sind die Partikel 7b monodispers, also von einheitlicher Größe, und kugelförmig, dargestellt. Dies ist jedoch nicht zwingend erforderlich. Zweckmäßig ist es aber, wenn die Größe und Verteilung der Partikel so ist, dass sich im Hinblick auf die Größenskala der Auflösung des bildgebenden Prüfverfahrens und somit auch der dort zu detektierenden Defekte eine homogene Verteilung des Kontrastmittels und damit der Röntgenopazität ergibt. Auf diese Weise können auch hier unerwünschte Defekte sichtbar gemacht werden. Solche Defekte können z.B. ähnlich wie beim Beispiel der Figur 1 ausgebildet sein.

### Bezugszeichenliste

- 1: elektronische Baugruppe
- 3: elektronisches Bauteil
- 5: Substrat
- 7: elektrisch isolierendes Füllmittel
- 7a: erste Materialkomponente (Gießharz)
- 7b: zweite Materialkomponente (Kontrastmittel)
- 8a: erster Defekt (Luftblase)
- 8b: zweiter Defekt (Fülllücke)
- 8c: dritter Defekt (Delaminationsstelle)
- 13: Kontaktstelle des Bauteils
- 15: Kontaktstelle des Substrats
- 17: Bond-Bump
- 19: Bond-Draht
- A: Ausschnittsvergrößerung

## Patentansprüche

1. Elektronische Baugruppe mit wenigstens einem elektronischen Bauteil, welches zumindest teilweise mit einem elektrisch isolierenden Füllmittel umhüllt ist, wobei das elektrisch isolierende Füllmittel eine erste elektrisch isolierende Materialkomponente umfasst und als Nebenbestandteil eine zweite elektrisch isolierende Materialkomponente umfasst, welche als Röntgenkontrastmittel ausgebildet ist und eine höhere Dichte als die erste Materialkomponente aufweist.

2. Baugruppe nach einem der vorhergehenden Ansprüche, bei welcher das Röntgenkontrastmittel ein chemisches Element mit einer Ordnungszahl von wenigstens 22 aufweist.

3. Baugruppe nach einem der vorhergehenden Ansprüche, bei welcher das Röntgenkontrastmittel Iod, Barium, Zirconium, Wolfram, Strontium und/oder Titan umfasst.

4. Baugruppe nach einem der vorhergehenden Ansprüche, bei welcher das Röntgenkontrastmittel, im elektrisch isolierenden Füllmittel homogen verteilt ist und insbesondere im Falle von verteilten Partikeln eine Partikelgröße von höchstens 50 µm aufweist.

5. Baugruppe nach einem der vorhergehenden Ansprüche, bei welcher das Röntgenkontrastmittel in der ersten Materialkomponente dispergiert ist.

6. Baugruppe nach Anspruch 5, bei welcher das Röntgenkontrastmittel in Form von Nanopartikeln vorliegt.

7. Baugruppe nach einem der vorhergehenden Ansprüche, bei welcher das Röntgenkontrastmittel in dem Füllmittel einen Volumenanteil ausmacht, welcher zwischen 0,5 Volumenprozent und 20 Volumenprozent liegt.

8. Baugruppe nach einem der vorhergehenden Ansprüche, bei welcher die erste Materialkomponente ein Polymer und insbesondere ein Polymerharz ist oder umfasst, welcher bzw. welches insbesondere als Duroplast ausgebildet ist.

9. Baugruppe nach Anspruch 8, bei welcher die erste Materialkomponente ein Epoxidharz, ein Silikonharz, ein Polyurethanharz, ein Acrylharz, ein Polyesterharz, ein Vinylesterharz und/oder ein Phenolharz ist bzw. ein solches Material umfasst.

10. Baugruppe nach einem der Ansprüche 8 oder 9, bei welcher die erste Materialkomponente ein Härtermaterial umfasst, mit dem eine Vernetzungsreaktion des Kunstharzes bewirkt worden ist.

11. Baugruppe nach einem der vorhergehenden Ansprüche, bei welcher das wenigstens eine elektronische Bauteil auf einem Substrat angeordnet ist und ein Bereich zwischen dem elektronischen Bauteil und dem Substrat mit dem elektrisch isolierenden Füllmittel unterfüllt ist.

12. Baugruppe nach einem der vorhergehenden Ansprüche, bei welcher das wenigstens eine elektronische Bauteil auf einem Substrat angeordnet ist und ein von dem Substrat abgewandter Bereich des elektronischen Bauteils von dem elektrisch isolierenden Füllmittel umhüllt ist.

13. Baugruppe nach einem der vorhergehenden Ansprüche, bei welcher das wenigstens eine elektronische Bauteil ein Bauteil der Leistungselektronik ist.

14. Elektrisch isolierendes Füllmittel zur Umhüllung eines elektronischen Bauteils in einer elektronischen Baugruppe, welches eine erste elektrisch isolierende Materialkomponente umfasst und als Nebenbestandteil eine zweite elektrisch isolierende Materialkomponente umfasst, welche als Röntgenkontrastmittel ausgebildet ist und eine höhere Dichte als die erste Materialkomponente aufweist.

15. Verfahren zur Qualitätsprüfung einer elektronischen Baugruppe nach einem der Ansprüche 1 bis 13, bei dem mittels einer Röntgenmessung eine Bildgebung der Baugruppe erreicht wird.
